# EUROPEAN PATENT APPLICATION

(11) **EP 1 176 633 A2**
(43) Date of publication of application: **30.01.2002**
(21) Application number: 01306297.1
(22) Date of filing: 23.07.2001
(51) Int. Cl.: H01L 21/306, B08B 3/04, B05D 5/00, H01L 21/302

(54) **Surface treatment solution for polysilicon film and method of treating the surface of polysilicon film using the same**

(30) Priority: 25.07.2000 JP 2000224003
(71) Applicant: KANTO KAGAKU KABUSHIKI KAISHA, Chuo-ku Tokyo 103 (JP)
(72) Inventor: Hayashi, Hidekazu. c/o Kanto Kagaku K. K., Chuo-ku, Tokyo (JP); Kageyama, Kenji. c/o Kanto Kagaku K. K., Chuo-ku, Tokyo (JP)
(74) Representative: Ede, Eric

(57) **Abstract**

An inexpensive surface treatment solution that can selectively reduce the average roughness (Ra) of the surface of a polysilicon film formed by crystallization on an insulating substrate such as one made from glass with a laser annealing process. The surface treatment solution essentially comprises 0.01 to 0.5 wt% of hydrofluoric acid or 0.5 to 5 wt% of ammonium fluoride, 50.0 to 80.0 wt% of nitric acid and water.

## Description

### BACKGROUND OF THE INVENTION

The present invention relates to a surface treatment solution for a polysilicon film and a method of treating the surface of a polysilicon film and, more particularly, to a surface treatment solution for a polysilicon film preferably used for a channel semiconductor layer of a thin film transistor (TFT) of a liquid crystal display device and a method of treating the surface of such a polysilicon film.

Polysilicon has been used in a wide range of fields including various types of semiconductor device and liquid crystal display. The formation of polysilicon TFTs on quartz and glass substrates has been of special note as a technique to realize the high density of liquid crystal display devices and the low cost. It is an advantage that in the technical field of liquid crystal display devices, in particular in case that TFT having a polysilicon film is used as an active layer, TFT is used also for a drive circuit besides for the image pixel switching element, because high speed operation is possible and consequently the integral formation of the circuit can be achieved. In particular, the formation of a high quality polysilicon film on a glass substrate can reduce the cost.

The polysilicon film that functions as an active layer in a TFT can be formed by crystallization of an amorphous silicon thin film, which are deposited on an insulating substrate such as one made from glass etc, with a laser annealing process. With regard to a liquid crystal display device employing a TFT having a polysilicon film as an active layer, in particular in the case where the insulating substrate is made from glass, it is difficult to carry out a treatment at high temperature. It is therefore preferable to carry out the deposition of the polysilicon film at low temperature.

With regard to processes for crystallizing an amorphous silicon thin film at low temperature, there are a "solid phase growth process" and a "laser annealing process". A crystallization technique with the laser annealing process is now becoming mainstream. Although it is possible to grow a silicon nucleus at low temperature by the solid phase growth process and since the long time treatment is necessary, the mass production using this process is not suitable. As is disclosed in, for example, JP, A, 7-118443, since the laser annealing process employs a laser having a wavelength in the ultraviolet region, only the surface of the amorphous silicon film is heated and there is hardly any thermal influence on the substrate. As a result, an inexpensive substrate with low heat resistance such as a glass substrate can be used.

However, the surface (particularly the silicon grain boundary area) of a polysilicon film formed by crystallization with the laser annealing process has an average roughness (Ra) of about 10 nm due to aggregation of crystal particles accelerated by, for example, uneven distribution of the laser energy density and crystallization with rapid heating. Since the grain boundary, in particular the triple point of the grain boundary, is the last solidifying area, projections are easily formed by volume expansion resulting from the difference in density. The average roughness (Ra) is the average of the absolute values of the deviation of designated surfaces from a reference surface (a flat surface, i.e. the average height of the designated surfaces) and is a concept used to represent the degree of surface roughness. In the following equation representing the average roughness (Ra), S₀ denotes the area of the reference surface, Z₀ the height of the reference surface and F(X, Y) the height of a designated surface at X and Y.

### [Equation 1]

The higher the degree of surface roughness of a polysilicon film, that is to say, the average roughness (Ra), the greater the adverse affect on the transistor characteristics. Moreover, in the case of a polysilicon TFT-LCD (Thin Film Transistor Liquid Crystal Display) not only the TFT but also a driver LSI for driving the liquid crystal can be integrated on the glass substrate. Since contaminants such as metal impurities on the surface of a polysilicon film can cause the voltage resistance of the gate electrodes and the reliability of the elements and increase leakage current, etc., it is very important to clean the surface of the polysilicon film formed by crystallization with the laser annealing process. Therefore there has been a demand that the surface treatment solution can clean the surface of the polysilicon film, at the same time reduce the average roughness (Ra) of the polysilicon film surface and does not rough the silicon oxide film which is formed as a material for preventing impurity diffusion from the glass substrate.

With regard to techniques to planarize a polysilicon film, for example, JP, A, 10-200120 discloses a process employing a CMP (Chemical Mechanical Polishing) technique used in the production of semiconductors (CMP process). Moreover, JP, A, 2000-124457 discloses a process in which a polysilicon film is planarized by a dry etching process using a resist as a sacrificial film (etchback process). Furthermore, in order to planarize abnormally grown crystalline projections, JP, A, 2-163935 discloses a process in which the projections and a portion of the polysilicon surface are simultaneously oxidized and the oxidized layer is selectively removed using a liquid reagent.

On the other hand, it is reported that when an amorphous silicon film containing oxygen is polycrystallized by means of an excimer laser annealing device, the oxygen is segregated both in the projections and on the film surface, and carrier migration can be enhanced by removing the oxygen with a BOE (Buffered Oxide Etchant) (1997 SID International Symposium digest of technical papers, May 1997, pp. 485-488).

However, the above-mentioned prior art has the following unresolved problems.

In the case where a polysilicon film is planarized by the CMP process, although it is possible to reduce the average roughness (Ra) to 1 nm or below, the cost of CMP equipment is high and there is a possibility of contamination by impurities derived from the polishing agent. Moreover, since the CMP process requires an additional production step such as a post cleaning step, there is the problem that the productivity decreases.

In the case where a polysilicon film is planarized by the etchback process, since a resist as a sacrificial film is applied and dry etching is carried out using CF₄ gas, etc., there are the problems that the increase of production steps numbers decreases the productivity and the high cost of equipment and raw materials makes the process uneconomical.

Moreover, in the case where a process disclosed in JP, A, 2-163935 is employed, as is clear from the example of this publication, it is difficult to selectively oxidize only the surface of a polysilicon film. In particular, there is the problem that when a polysilicon film is wet-oxidized at 950°C not only the surface, but also the entire polysilicon film is oxidized.

The process using an amorphous silicon film containing oxygen has the problem that crystals cannot grow sufficiently due to the presence of a large amount of oxygen when crystallizing with the laser annealing process, etc. When the grain size is small, a high level of mobility cannot be obtained and adequate performance as a transistor cannot be exhibited. In the case where a BOE is employed, there is the problem that the silicon oxide film formed for preventing diffusion of impurities from the glass substrate is etched so increasing the average roughness (Ra) of the silicon oxide film.

### SUMMARY OF THE INVENTION

The present invention has been carried out in view of the above-mentioned circumstances. It is therefore an object of the present invention to provide an inexpensive surface treatment solution that can selectively reduce the average roughness (Ra) of the surface of a polysilicon film formed by crystallization on an insulating substrate such as one made from glass with the laser annealing process without roughing the surface of the silicon oxide film and without employing the CMP process or the etchback process, with which it is difficult to reduce the cost and enhance the productivity, thereby solving the above-mentioned problems.

As a result of an intensive investigation by the present inventors in order to achieve the above-mentioned object, it has been found that the above-mentioned problems can be solved by a surface treatment solution containing hydrofluoric acid or ammonium fluoride and nitric acid in specified concentrations. The present invention has thus been accomplished.

The present invention relates to the surface treatment solution for a polysilicon film consisting essentially of 0.01 to 0.5 wt% of hydrofluoric acid or 0.5 to 5 wt% of ammonium fluoride, 50.0 to 80.0 wt% of nitric acid and water.

The present invention relates to the above-mentioned surface treatment solution wherein it is used for cleaning / planarizing the surface of a polysilicon film forming a thin film transistor.

The present invention relates to the above-mentioned surface treatment solution wherein the polysilicon film is formed on an insulating substrate made from glass and does not rough the silicon oxide film which is formed on the insulating substrate.

Further, the present invention relates to a process for treating the surface of a polysilicon film wherein the surface of a polysilicon film formed by crystallization of an amorphous silicon film, which is deposited on an insulating substrate, with a laser annealing process is treated with any one of the above-mentioned surface treatment solutions.

Furthermore, the present invention relates to the above-mentioned process wherein the treatment with the surface treatment solution is carried out at 5 to 60°C for 10 seconds to 30 minutes.

The present invention relates to the above-mentioned process wherein the polysilicon film is a polysilicon film forming a thin film transistor.

The present invention relates to the above-mentioned process wherein the polysilicon film is a polysilicon film formed on an insulating substrate made from glass.

The above-mentioned surface treatment solution may be used, for cleaning / planarizing the surface of a polysilicon film forming a thin film transistor or may be used for cleaning / planarizing the surface of a polysilicon film formed on an insulating substrate made from glass.

Moreover, in accordance with the present invention, there is provided a process for treating the surface of a polysilicon film wherein the surface of a polysilicon film formed by crystallization of an amorphous silicon film, which is deposited on an insulating substrate, with the laser annealing process is treated with the above-mentioned surface treatment solution. In the above-mentioned surface treatment process, the treatment temperature with the surface treatment solution is preferably 5 to 60°C and the treatment time is 10 seconds to 30 minutes. In the above-mentioned surface treatment process, the polysilicon film may be a polysilicon film forming a thin film transistor or may be a polysilicon film formed on an insulating substrate made from glass.

A liquid composition containing hydrofluoric acid or ammonium fluoride and nitric acid is known in the prior art as an etching solution for silicon (ref., for example, JP, A, 6-21034, Kiyotake Naraoka "Precision Micro Processing in Electronics", Sogo Denshi Publishing, 1980, p. 83, Ritsuo Takizawa, Toshiro Nakanishi, Kouichirou Honda and Akira Ohsawa "Ultraclean Technique for Silicon Wafer Surfaces with HNO₃-HF Systems", Japanese Journal of Applied Physics, Vol., 27, No. 11, Nov., pp. L2210-L2212). However, the concentrations of hydrofluoric acid or ammonium fluoride and nitric acid in these etching solutions are all different from the concentrations of the respective components in the surface treatment solution of the present invention. The object of the present invention, that is to say, reduction in the average roughness (Ra) of the surface of a polysilicon film after laser annealing cannot be achieved by, for example, a mixed acid of hydrofluoric acid(concentration:50% by weight) : nitric acid (concentration: 61% by weight) : water at a 1:60:60 ratio by volume (Kiyotake Naraoka "Precision Micro Processing in Electronics", Sogo Denshi Publishing, 1980) or a mixed acid containing hydrofluoric acid, nitric acid and acetic acid, both of which are known as standard etching solutions for polysilicon.

With regard to etching solutions for silicon, liquids containing an alkaline component are known, but these liquids exhibit anisotropic etching and the etching mode depends on the direction of the silicon crystal plane. As a result, the average roughness (Ra) of the surface of a polysilicon film increases. Accordingly, these solutions cannot be used for cleaning / planarizing the polysilicon surface formed by crystallization with the laser annealing process.

The effect obtained by the surface treatment solution of the present invention is outstanding when taking into consideration the performance of the etching solutions known in the art containing hydrofluoric acid or ammonium fluoride and nitric acid, which have a similar composition to that of the surface treatment solution of the present invention.

### BRIEF DESCRIPTION OF THE DRAWINGS

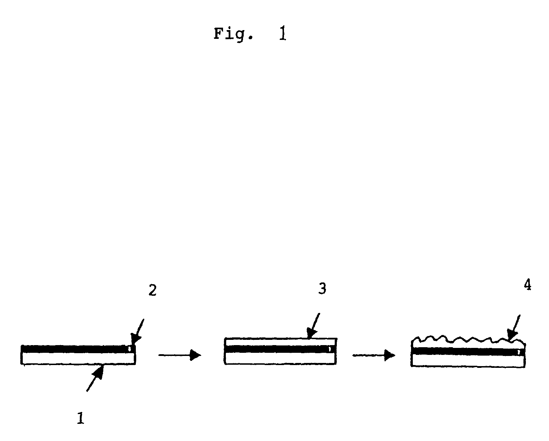

FIG. 1 shows a schematic process diagram of the steps forming a polysilicon film on the surface of an insulating substrate.

### DETAILED DESCRIPTION OF THE PREFERRED EMBODIMENTS

Since the surface treatment solution for a polysilicon film of the present invention has a high concentration of nitric acid, the oxidation reaction of polysilicon is the rate-determining step, and since the concentration of hydrofluoric acid or ammonium fluoride is very low, the average roughness (Ra) of a polysilicon film surface can be reduced regardless of the direction of the polysilicon crystal axis. The hydrofluoric acid or ammonium fluoride and nitric acid forming the surface treatment solution for a polysilicon film of the present invention are widely used as reagents for semiconductors, and it is therefore easy to obtain highly pure reagents at low cost. The surface treatment solution of the present invention can thus be produced at low cost and there is no possibility of back contamination of the polysilicon film with impurities.

With regard to the surface treatment solution for a polysilicon film of the present invention, the concentration of hydrofluoric acid is 0.01 to 0.5 wt% or the concentration of ammonium fluoride is 0.5 to 5 wt%. When the concentration of hydrofluoric acid is higher than 0.5 wt% or that of ammonium fluoride is higher than 5 wt%, the speed of planarizing the polysilicon increases, which worsens the planarity of the polysilicon surface. When the concentration of hydrofluoric acid is lower than 0.01 wt% or the concentration of ammonium fluoride is lower than 0.5 wt%, the speed of planarizing decreases, which worsens the productivity. The concentration of hydrofluoric acid is preferably 0.05 to 0.2 wt% and the concentration of ammonium fluoride is preferably 1 to 4 wt%.

With regard to the surface treatment solution for a polysilicon film of the present invention, the concentration of nitric acid is 50.0 to 80.0 wt%. When the concentration is less than 50.0 wt%, the hydrofluoric acid etching reaction becomes the rate-determining step so worsening the planarity of the polysilicon surface. When the concentration is higher than 80.0 wt%, the nitric acid oxidation becomes the rate-determining step and the etching rate decreases, which is not practical. Moreover, it is difficult and economically undesirable to produce nitric acid having a concentration of higher than 80.0 wt%. The concentration of nitric acid used for the present invention is preferably 60.0 to 70.0 wt%.

The surface treatment solution of the present invention can be suitably used for cleaning and planarizing the surface of a polysilicon film formed by crystallation of an amorphous silicon film, which is deposited on an insulating substrate, with the laser annealing process. In particular, the agent can be suitably used for cleaning and planarizing the surface of a polysilicon film forming a thin film transistor. Moreover, since the surface treatment solution of the present invention can be provided with high purity so causing less contamination due to impurities, it can be particularly suitably used for cleaning and planarizing the surface of a polysilicon film formed on an insulating substrate made from glass.

When the surface of a polysilicon film is cleaned and planarized with the surface treatment solution of the present invention, the treatment temperature is preferably 5 to 60°C and the treatment time is 10 seconds to 30 minutes. When the treatment temperature is too low, the activity of the surface treatment solution decreases and the agent cannot exhibit the planarizing effect. When the temperature is too high, it becomes difficult to control the temperature of the treatment equipment and the effect is not stable. When the treatment time is too short, the surface treatment solution cannot exhibit the effect. When the time is too long, the polysilicon film itself is etched so introducing the possibility of losing the film. The treatment temperature is more preferably 10 to 50°C and the treatment time is more preferably 1 to 20 minutes.

### EXAMPLES

The present invention is explained further in detail by the examples and comparative examples below but the present invention is not limited thereby. The average roughness (Ra) of the surface of a polysilicon film in the present invention was measured using an AFM (Atomic Force Microscope) manufactured by Takano K.K. The water used for preparation and analysis was ultrapure water, and the reagents used in the examples and comparative examples were of ultra high purity grade.

### Examples 1 to 6

As shown in FIG. 1, a coating film 2 made of SiO₂ film or SiN was formed on an insulating substrate 1 made from, for example, glass by a sputtering process or a plasma CVD (Chemical Vapor Deposition) process for the purpose of preventing diffusion of impurities from the substrate. An amorphous silicon film 3 was formed on this coating film 2 by the plasma CVD process so that the film 3 had a film thickness of 10 to 70 nm (preferably 20 to 60 nm). This amorphous silicon film 3 was subjected to annealing by an excimer laser with a laser power of about 300 mJ/cm² to give a polysilicon film 4.

The laser used for the laser annealing may be an XeCl, ArF or KrF excimer laser. Prior to the laser annealing, polycrystallization by solid phase growth may occur in a nitrogen atmosphere at 600°C

The polysilicon films 4 formed by crystallization with the laser annealing process as shown in FIG. 1 were immersed in surface treatment solutions having each of the compositions shown in TABLE 1 under the conditions shown in TABLE 1. Subsequently, the films 4 were washed with ultrapure water and dried by blowing nitrogen, and the average roughnesses (Ra) of the polysilicon film and the SiO₂ film were measured using AFM. The results are given in TABLE 1.

### Comparative Examples 1 to 10

A polysilicon film was treated in the same manner as in Examples 1 to 6 except that surface treatment solutions having each of the compositions shown in TABLE 1 were used. The results are given also in TABLE 1.

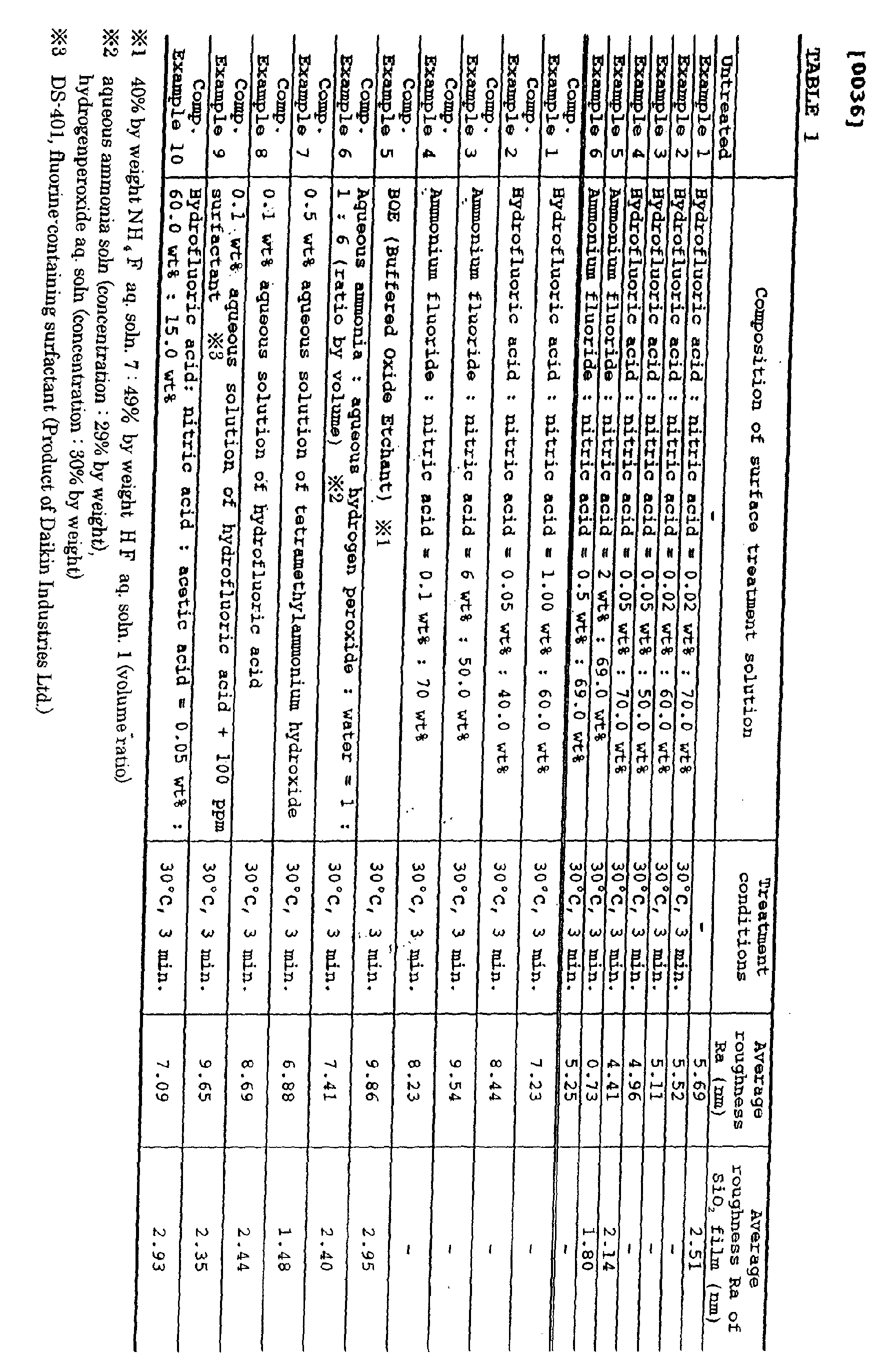

It is clear from TABLE 1 that the use of the surface treatment solutions of Examples 1 to 6 could reduce the average roughness (Ra) of the surface of a polysilicon film formed crystallization with the laser annealing process without employing the CMP process or the etchback process. On the other hand, when using the cleaning / planarizing agents of Comparative Examples 1 to 4, 8 and 9 in which the concentration of any one of the hydrofluoric acid, ammonium fluoride and nitric acid was outside the range of the present invention, when using a BOE and when using a conventional silicon etching solution such as the alkaline solutions of Comparative Examples 6 and 7, the average roughness (Ra) of the surface of the polysilicon film could not be reduced sufficiently. Moreover, it can be seen that when, using the BOE, the average roughness (Ra) of the silicon oxide film increased.

### [Effects of the Invention]

In accordance with use of the surface treatment solution of the present invention, it is possible to reduce the average roughness (Ra) of the surface of a polysilicon film, which is formed by crystallization with the laser annealing process, without roughing the surface of the silicone oxid film and without employing the CMP process or the etchback process. Since the present invention can be suitably applied to the cleaning and planarizing of the surface of a polysilicon film formed on an insulating substrate, particularly one made from glass, the present invention can contribute to enhancing the productivity of thin film transistors and reducing the production cost.

Embodiments of the present invention have been described in detail above, but the present invention can be modified in a variety of ways without departing from the scope of the appended claims.

### [Fig. 1]

1 Insulating substrate
2 Coating film made of SiO₂ or SiN
3 Amorphous silicon film
4 Polysilicon film

## Claims

1. A surface treatment solution for a polysilicon film consisting essentially of 0.01 to 0.5 wt% of hydrofluoric acid or 0.5 to 5 wt% of ammonium fluoride, 50.0 to 80.0 wt% of nitric acid, and water.

2. The surface treatment solution according to Claim 1 wherein it is used for cleaning / planarizing the surface of a polysilicon film forming a thin film transistor.

3. The surface treatment solution according to Claim 1 or 2 wherein the polysilicon film is formed on an insulating substrate made from glass and does not rough the silicone oxide film which is formed on the insulating substrate.

4. A process for treating the surface of a polysilicon film with the surface treatment solution according to Claim 1 wherein the surface of a polysilicon film are formed by crystallization of an amorphous silicon film, which is deposited on an insulating substrate, with a laser annealing process.

5. The process according to Claim 4 wherein the treatment with the surface treatment solution is carried out at 5 to 60°C for 10 seconds to 30 minutes.

6. The process according to Claim 4 or 5 wherein the polysilicon film is a polysilicon film forming a thin film transistor.

7. The process according to Claim 4 wherein the polysilicon film is a polysilicon film formed on an insulating substrate made from glass.
